(19) **Europäisches Patentamt**

**European Patent Office**

**Office européen des brevets**

(11) **EP 1 308 732 A1**

(12) **EUROPEAN PATENT APPLICATION**

(43) Date of publication:
**07.05.2003 Bulletin 2003/19**

(51) Int Cl.⁷: **G01P 5/00**, H01S 5/183

(21) Application number: **01204155.4**

(22) Date of filing: **01.11.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **FORSKNINGSCENTER RISO**
**4000 Roskilde (DK)**

(72) Inventors:
• **Hanson, Vagn Steen Gruner**
**4640 Fakse (DK)**

• **Jakobsen, Michael Linde**
**1970 Frederiksberg C (DK)**

(74) Representative: **Elmeros, Claus**
**Patentgruppen ApS,**
**Arosgaarden,**
**Aaboulevarden 31**
**8000 Aarhus C (DK)**

(54) **Optical device and method for measuring velocity**

(57) In the field of non-intrusive velocity measurement, a device and a method for measuring the velocity of objects, particles or fluid flow is provided. The device comprises transmitter means (1) comprising at least one linear array (101) of surface emitting light sources ($102_x$), said light sources (102) being arranged in a linear configuration spaced apart by a predetermined separation distance (d), an optical system (103-105) including at least one imaging lens directing the substantially coherent electromagnetic radiation (10) emitted from the light sources (102) into a measurement region in a predetermined manner producing an array of fringes or spots (4) spaced apart with a predetermined fringe distance ($\Lambda$) corresponding to the separation distance (d) between the light sources (102), receiver means (2) comprising light manipulating means (202, 203) directing the electromagnetic radiation (20) scattered from the measurement region to detection means including at least one detector (201, 204, 205) detecting the scattered electromagnetic radiation (20) from the measurement region as an object (3) passes through the measurement region, detector processing means processing the detected signals from the detector means corresponding to the particle(s) and surface (3) passing the fringes (4) in the measurement region.

According to the invention, the surface emitting light sources are Vertical Cavity Surface Emitting Laserdiodes (VCSEL). Hereby, a low power consumption is achieved just as a reliable and simple light source is provided resulting in a robust non-intrusive velocity measurement system.

**EP 1 308 732 A1**

## Description

The present invention relates to a device for measuring the velocity of an object or particle, particularly to non-intrusive optical measurement of the velocity of fluid flows, single particles, or solid objects.

Basically, two techniques for non-intrusive optical measurement of velocity of fluid flows or solid objects are known in the art.

According to a first principle, two parallel laser beams are focused in a measurement volume and two photo-detectors collect the scattered light each time a particle passes through the focus of the laser beams. The speed of the particle is determined by cross-correlating the signals from the two detectors, i.e. by tracking the time it takes a particle to go from one focused spot to the next. This technique is normally referred to as the *Time-of-Flight Anemometry* or TOF principle - sometimes called a "two-spot" system. In this technique, the light from a laser is split into two laser beams that must be parallel and both must have their waists (focal points) located in the measurement volume with a well-defined mutual distance. This demands a delicate alignment of the system and usually requires a stable laser. The measurement volume is quite narrow so the system must be positioned with great accuracy in order to perform the desired measurements.

Another principle is often referred to as the *Laser Doppler Anemometer* (LDA in case of flow measurement) or *Laser Doppler Velocimetry* (LDV in case of solid-body measurement) principle. According to this technique, two laser beams from the same laser intersect at their beam-waists. A set of parallel fringes of maximum energy will be created in the measuring volume. A particle scatter Doppler shifted light from each beam as it passes through the measurement area and a photo-detector mixes these two optical signals to give an electrical signal with a modulation frequency proportional to the particle velocity. The velocity is determined by Fourier transformation and/or counting zero-crossings of the high-pass filtered signal. The LDA principle requires that the beam waists must be located at the intersection point, which demands an accurate alignment. In case the two beams do not intersect at the beamwaists, the frequency of the detected signal will depend on the crossing point of the particle, which is unacceptable. The laser must be frequency stable in order to control the fringe spacing, just as a high power laser is often required for velocity measurement according to this LDA principle - two issues that both increase the cost of the laser system.

From European patent No. 0 291 708 a device for measuring the speed of moving light-scattering objects according to the LDA principle is known. This device comprises stacked arrays of conventional edge-emitting laser diodes arranged with a defined separation from one another producing a periodic intensity distribution in the measuring volume. As the laser light is scattered from the objects in the measurement region into the detector, a periodic signal is observed. In order to be able to determine the direction, the laser diode array is arranged such that no emission occurs in at least one location of a laser diode.

Conventional laser diode arrays comes in two basic kinds: In one kind the individual laser diodes are still phase-coupled, while in the other kind they are individually addressable and have independent phases. The phase-coupled laser diode array has several drawbacks that seriously hinder its application to velocity measurement, such as described in the article *"Flow-velocity measurements with a laser diode array"*, Azzazy, et al., APPLIED OPTICS, Vol. 36, No. 12, 20 April 1997, pp 2721-2729.

The drawbacks of the phase-coupled laser diodes and this technology are that the lasers have a relative large beam-to-beam intensity variation, a low modulation depth for the fringe pattern, and an undesired a double-peak intensity modulation in the far-field due to interference between light from different sources in the diode array.

By addressing the individual laser diodes these drawbacks will disappear. However, conventional laser diodes are expensive, fragile at handling and they have relatively high power consumptions. Additionally, conventional laser diodes emit light at large divergence angles (approx. 30 degrees) calling for a high numerical aperture for the lenses used for collecting the emitted light. This will further increase the cost of the system, or introduce detrimental diffraction effects in the measuring volume if an insufficient numerical aperture of the lens is used with the purpose of cutting the cost. In 2D configuration, the individual laser sources cannot be addressed.

These drawbacks have meant that this technique has not matured into a commercially available velocity measuring equipment.

On this basis, the object of the invention is to provide a device and a method of the initially mentioned kind that overcomes the above-mentioned drawbacks with non-intrusive velocity measurement techniques.

This object is achieved according to the invention by a device and a method for measuring the velocity of objects, particles, or a fluid flow, comprising transmitter means comprising at least one linear array or a two-dimensional array of surface emitting lasers, said laser sources being arranged in a configuration spaced apart by a predetermined separation distance ($d$), an optical system including at least one imaging lens directing the electromagnetic radiation emitted from the laser sources into a measurement region in a predetermined manner producing an array of fringes or spots spaced apart with a predetermined distance ($\Lambda$) corresponding to the separation distance ($d$) between the laser sources, receiver means comprising light manipulating means directing the electromagnetic radiation scattered from the measurement region to detection means including at least one detector detecting the scattered electromagnetic radiation from the measurement region as an object passes through the measurement region, detector processing means processing the detected signals from the detector means corresponding to the object passing the fringes in the measurement region. The surface emitting light sources could be Vertical Cavity Surface Emitting Laserdiodes (*VCSELs*). By the invention, it is realised that an equivalent solution could be high efficiency, infra red light emitting diodes instead of the laser sources if it is appropriate in an actual application. By a system according to the invention, it is realised that coherent as well as in-coherent light scattered from the light sources may be used depending on the nature of the non-intrusive velocity measurement, unlike the known systems where it is imperative that the emitted light is coherent.

By the invention, a device and a method are provided using non-expensive light sources. The system according to the invention is a robust system that is easy to align. The system only requires a medium or low power of each of the emitting light sources. By using VCSEL arrays, relatively inexpensive light sources are provided that produce numerous benefits compared to the prior art techniques. The VCSEL arrays may be produced from one wafer instead of using stacked laser diodes. This makes alignment and calibration of the system easy. Moreover, there is only a minor temperature influence on the calibration of the system according to the invention as a temperature change may primarily change the emitted wavelengths, which do not enter into the calibration factor. The VCSELs are small structures (each of approximately size 0.3 mm X 0.3 mm), which makes it possible to produce a compact system at relatively low costs. The light sources are produced in wafers, where the individual VCSELs are placed in a rectangular array with a mutual distance of approx. 0.25 mm. The desired linear or 2-D configuration of VCSELs can thus be cut out of one wafer. Furthermore, the individual VCSELs can be functionally controlled while being placed in the wafer, so as to assure that a functioning array is obtained before any expensive processing has taken place. This is advantageous as a robust system can be produced, which is simple in assembly as the individual sources are born with the predetermined mutual distance. Due to the characteristics of the VCSELs, no interference between light scattered from the individual beams occurs, making signal analysis easy. The system does not depend on the spatial coherence of the electromagnetic radiation.

According to the invention, the array of light sources is imaged via the optical system that is designed as a clean-imaging system sometimes called a "4-f system", i.e. with two imaging lenses arranged such that the emitted light passes through both lenses so that the fringe distance is independent of the distance to the exit lens. The projected fringe spacing in the measuring volume is determined by the separation distance between the VCSELs (approx. 0.25 mm) and the magnification of the optical system. Since the VCSELs are individually controllable, an individual modulation of the fringes is possible, it being a space- and/or time-dependent modulation. An arbitrary number of fringes may be produced in the measurement volume according to the requirements of the actual application. The velocity measurement is almost independent of temperature, just as it is possible to determine the direction of the particle passing through the measurement region in a simple manner.

The synthetic laser Doppler system according to the invention may be regarded as an extended TOF system. Electronic processing of the detected signals may be carried out in a relative simple manner, which only demands a limited amount of computer power. Hereby, a real time measurement may be provided in an inexpensive and reliable way.

In a basic set-up, the linear array of light sources emit electromagnetic radiation in the near-infrared or visible spectrum through an imaging lens of focal length $f$ focusing the light beams in the measurement volume producing a linear array of spots. The spot distance $\Lambda$ is determined by:

For imaging, we have $1/b + 1/g = 1/f$ giving the spot distance $\Lambda = d \cdot b/g$, where

$d$ is the separation distance between the individual light sources,

$b$ is the distance between the lens and the measurement volume, and

$g$ is the distance between the linear VCSEL array and the lens.

Preferably, the optical system includes a cylinder lens. By introducing a cylindrical lens, the intensity pattern produced in the image plane of the measurement volume will be in the form of parallel planes, usually named *fringes*. By use of the cylinder lens, fringes with an aspect ratio, i.e. a "fringe width over fringe thickness" of arbitrary value may be produced. This feature may produce a relatively large measurement volume created in a simple manner with low power consumption.

In another embodiment of the invention, the imaging optical system includes two lenses, here named "clean imaging". The two lenses are arranged such that the fringes are produced by the emitted light from the laser array passing through both lenses and - if deemed appropriate - also through a cylinder lens situated in the optical system, e.g. between the two lenses. Hereby, the fringe spacing or spot separation $\Lambda$ becomes independent of the distance from the exit lens. In a first version of this embodiment, the cylinder lens is positioned with the lens centre line generally parallel to the linear direction of the laser source array. The fringe spacing $\Lambda$ is in this case determined by

$$\Lambda = d \cdot f_2/f_1,$$

where

$d$     is the separation distance of the light sources in the array,

$f_1$     is the focal distance of the first lens, and

$f_2$     is the focal distance of the second, exit lens.

Advantageously, the distance between the array of light sources and the first lens is $f_1$, the distance between the exit, second lens and the image plane of the measurement volume is $f_2$, and the distance between the two lenses is $f_1 + f_2$ with the cylinder lens located with the respective focal distances from each of the lenses. By the invention, it is realised that the cylinder lens may be arranged in different planes according to preferred preferences in a particular application.

In a variant of the embodiment, the cylinder lens is positioned with the lens centre line inclined relative to the linear direction of the laser source array or arrays. By rotating the cylinder lens, a closer fringe distance is produced in the imaging plane whilst maintaining the equidistant fringes. In a further variant of this embodiment, a plurality of linear arrays, i.e. a 2-D array, of surface emitting laser sources is parallelly arranged. Hereby, the fringes may be equidistantly positioned and a measurement volume with particular small fringe spacing may be obtained increasing the accuracy of the velocity measurement.

In another embodiment, two linear surface emitting laser source arrays are arranged in two directions, preferably mutually orthogonal. Hereby, a system for simultaneous velocity measurement in two directions is obtained. In this embodiment, the optical system may be similar to the single direction measurement system described above. The emitted electromagnetic radiation may have different wavelengths, different modulation frequencies or different coding in each of the arrays. Hereby, the detection system may easily be adapted to detecting velocities in both directions. The optical system in these two direction measurement embodiments may be provided by a cylinder lens for each array in order to produce overlapping fringe patterns in the measurement volume. However, it is realised that a common cylinder lens that is inclined relative to both arrays may be provided, just as other optical manipulating means may be provided in order to obtain the desired fringe patterns.

In another preferred embodiment, two detectors are successively arranged in the direction of measurement, preferably in the Fourier plane of the collecting lens. Hereby, the signals in the two detectors, as a light-scattering particle passes through the fringe pattern in the measurement volume, will observe the same modulation frequency but with a possible phase shift. This phase shift depends on the ratio between the particle size compared with the fringe spacing, as well as on the ratio between the detector spacing and the focal length of the lens of the receiving means. This means that not only the velocity but also the direction of movement and the particle size are determined.

The position of the detectors, i.e. the receiving means may be chosen according to the circumstances. The measured frequency of the temporal signal will be independent on the actual position of the detector system.

In another preferred embodiment, the optical system includes a beam splitter diverting the electromagnetic radiation reflected from the object to the receiver means. This allows for a particularly compact design of a system according to the invention.

In a particular embodiment, a grating or diffractive optical element with lines parallel with the axis of the laser array is provided in front of the beam splitter and an array of detectors corresponding to the laser array is arranged. Each laser beam is split into two new beams, which are incident on the target at different angles relative to the direction of movement of the target surface (out-of-plane rotation). Due to the effect of Doppler shift and by using optical mixing at the detectors, it is possible to measure out of plane relative angular displacement about the $y$-axis as a function of the $y$-position along the shaft, i.e. in the direction of the linear array of light sources, e.g. the torsional twist of a structure. The relative angular displacement is related to the phase change given by:

$$\Delta\Phi(y) = 4\pi f\theta(y)/\Lambda_g,$$

where

$\Delta\Phi(y)$     is the phase change of the detected signal at position $y$.

$f$     is the focal length of the exit lens,

$\theta(y)$     is the angular displacement about the $y$-axis as a function of the $y$-coordinate, and

$\Lambda_g$     is the fringe spacing of an intermediate grating.

In another preferred embodiment, a grating or diffractive optical element with lines perpendicular to the axis of the laser array is provided and where a corresponding array of detectors is arranged. The grating splits each laser beam in to two new laser beams, which hit the target slightly shifted in position in the $x$ direction. By doing optical mixing of the backscattered light at the detectors the elongation of the target in the z direction can be measured in points along the $x$-axis. Hereby, tilt, bending or vibration of the target surface can be determined. The mechanical measure can be related to the optical phase difference given by:

$$\Delta\varphi(x)=\frac{4\cdot\pi\cdot f}{\Lambda_g}\cdot\frac{\partial z}{\partial x}(x)$$

where

$\Delta\varphi(x)$     is the optical phase difference experienced by a pair of sub-beams on their way from the grating, to the target and back,

$f$     is the focal length of the exit lens,

$\Lambda_g$     is the fringe spacing of an intermediate grating and

$\frac{\partial z}{\partial x}(x)$     is the tilt/bending of the surface about the $y$-axis as a function of $x$.

As an alternative to the back-scattering mode, the receiving means may be located in a position such that the emitted electromagnetic radiation is diffracted by an object passing the measurement region being received by the electromagnetic radiation, i.e. the receiving means are positioned closely behind the measurement volume relative to the transmitted light, which as well is placed in close proximity to the scattering without any lenses in between. In particular, for flow measurements, this may be advantageous, as an example, in a fluid flow channel with scattering particles. The particles will shadow the incident light and one large detector will collect the transmitted light diffracted by the particle. Optionally, an optical transmission grating is arranged in front of the detector, whereby the modulated signal received by the detector may be enhanced.

By this embodiment, a particularly compact configuration is provided. The distance from the VCSEL array to the centre of the flow channel may be approx. 1 mm. A practical application of this compact and simple system could be to measure the flow in a capillary tube.

Each VCSEL source in the array may be controlled independently. In particular, the electromagnetic radiation from the VCSEL source array may be provided with a time- and space-dependent encryption, such as pulses, phase or frequency shifts of intensity modulation or the like, for distinguishing the individual laser sources and/or each array of laser sources from one another. Hereby, a "running light" may be provided. This makes it possible to determine the direction of the displacement by simple electronic processing and to code the signal from various projected arrays in the measuring volume.

The signal processing means may be adapted with means for determining the displacement and/or the velocity of a single particle. As a supplement or as an alternative, the signal processing means may be adopted with means for determining the displacement and/or the velocity of a solid surface or a flow of many particles in the measuring volume at the same time.

In the following, the invention is described in more detail with reference to the accompanying drawings, where:

fig. 1     is a schematic illustration of a basic transmitter- and detector set-up of a system according to the invention,

fig. 2     is a schematic side view of a simple transmitter design,

fig. 3     is a schematic view of a basic transmitter design,

fig. 4     is a preferred embodiment of a transmitter in a measuring system according to the invention,

fig. 5     shows an embodiment of the system according to the invention for measuring velocity in two directions,

fig. 6     shows a particular embodiment of the receiver means for determining both velocity, direction and particle size,

figs. 7 and 8     show a particular compact configuration of a system according to the invention,

figs. 9a and 9b     show details of an embodiment of the invention producing a higher light source density,

fig. 10     shows a schematic side view of an embodiment of the invention for measuring torsional twist,

fig. 11     shows a schematic side view of an embodiment of the invention for tilt or vibration,

fig. 12     is a diagram of an electronic processor for the signal processing means in a system according to the invention in frequency mode adapted for measurements of many particles or a solid surface,

fig. 13     is a diagram of the electronic processing in frequency mode adapted for measurements of single particles, and

fig. 14     is a diagram of the electronic processing in correlation, i.e. zero-crossing mode.

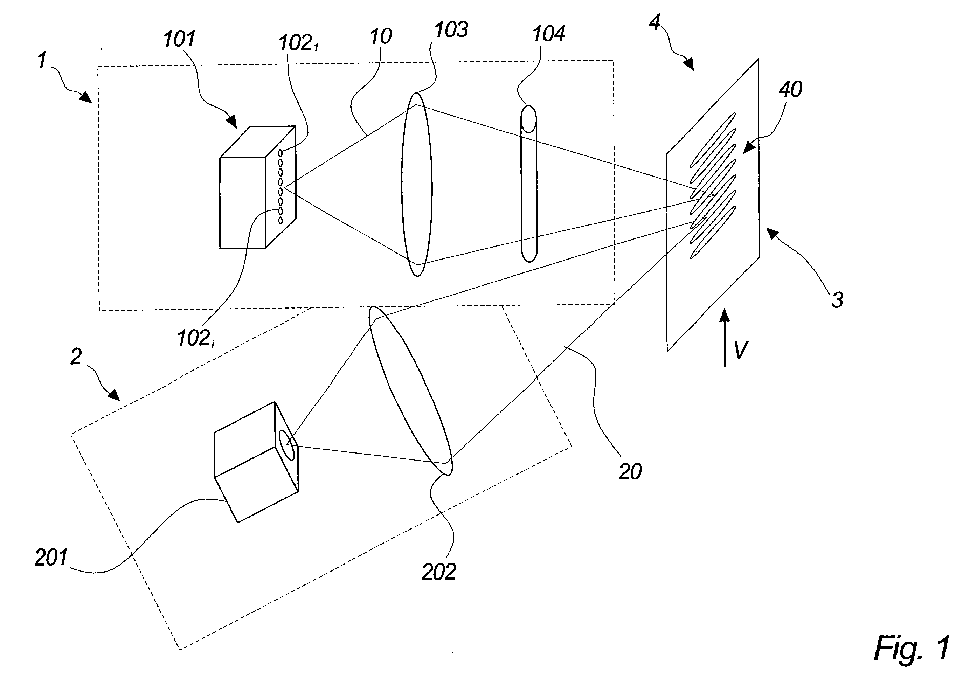

In figure 1, a schematic set-up of the device for non-intrusive velocity measurement according to the invention is shown. A transmitter 1 transmits electromagnetic radiation 10 from a surface emitting light source array 101, including a linear array of VCSELs $102_{1..i}$, through an optical system including one or more lenses 103, 104, towards a measurement volume 4 producing an array of fringes 40. This electromagnetic radiation 10 is reflected off an object or particle 3 passing through the measurement volume with a velocity v and this reflected electromagnetic radiation 20 is detected in a receiver 2, including a detector 201 and an imaging lens 202. The VCSELs are advantageous, since a laser diode of the VCSEL (Vertical Cavity Surface Emitting Laserdiode) type is inexpensive in purchase, has low power consumption and has better temperature stability than the alternative laser sources. Moreover, the VCSELs emit a circularly symmetric intensity pattern without inherent spherical aberration. The wavelength is typically approx. 850 nm. The VCSEL is produced as a chip on a wafer and is open for ASIC implementation.

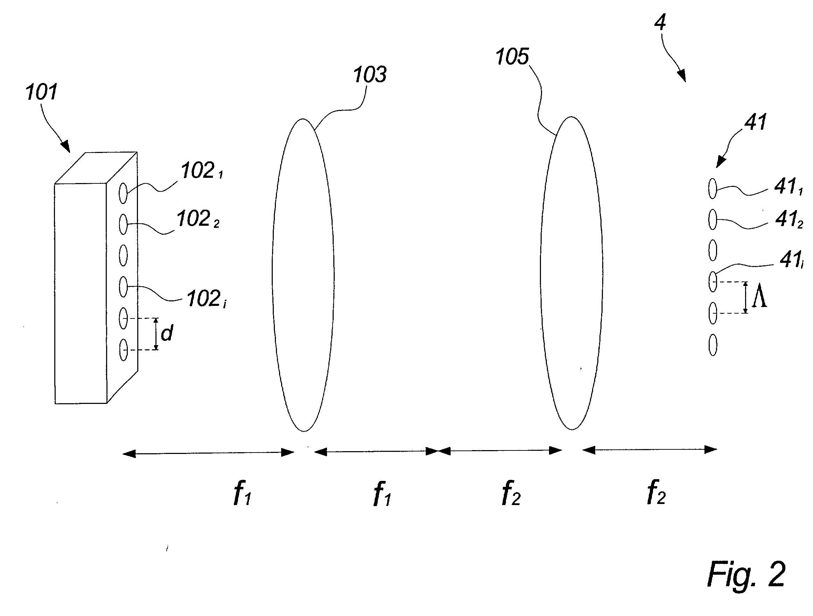

In fig. 2, an embodiment of the transmitter 1 is shown, where the optical system includes a first and a second imaging lenses 103 and 105. By providing a second, exit lens 105 in the optical system, the system scaling factor becomes independent or at least less dependent on the distance between the exit lens 105 and the measurement volume 4. The light beams forming the intensity pattern 41 in the form of spots 41 ($41_1$, $41_2$, .., $41_i$) are directed into substantially parallel light beams by the exit lens 105.

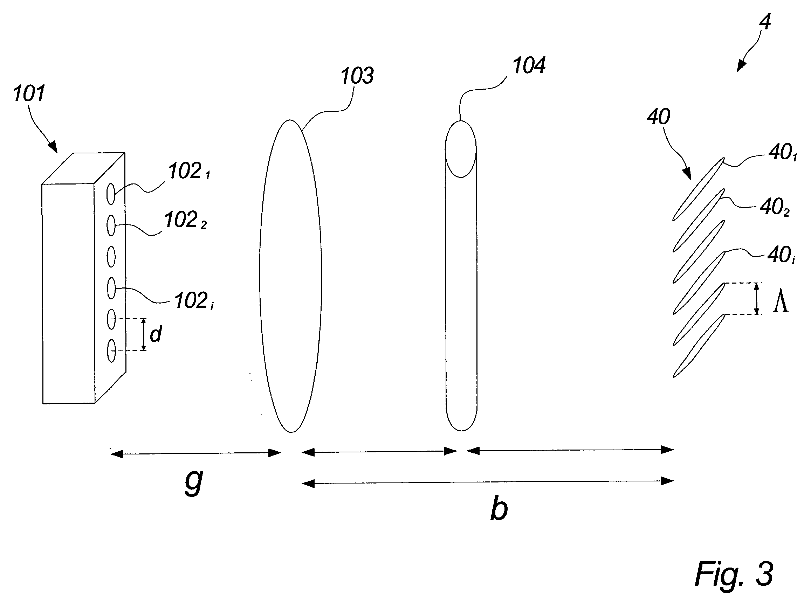

In fig. 3, a cylinder lens 104 is arranged in the optical system after the first imaging lens 103. By this cylinder lens 104, the array of light beams from the VC-SELs $102_i$ are converted into an array of linear, parallel fringes $40_1$, $40_2$, ..., $40_i$. When the distance from the transmitter array 101 of light sources 102 to the imaging lens 103 is $g$ and the distance from the imaging lens 103 to the measurement volume 4 is $b$, the connection between the separation distance d and the fringe spacing $\Lambda$ is:

$$\Lambda = d \cdot b / g.$$

In the embodiment shown in fig. 3, the fringe spacing is dependent on the distance from the exit lens - in the system shown in fig. 3 as the lens 103.

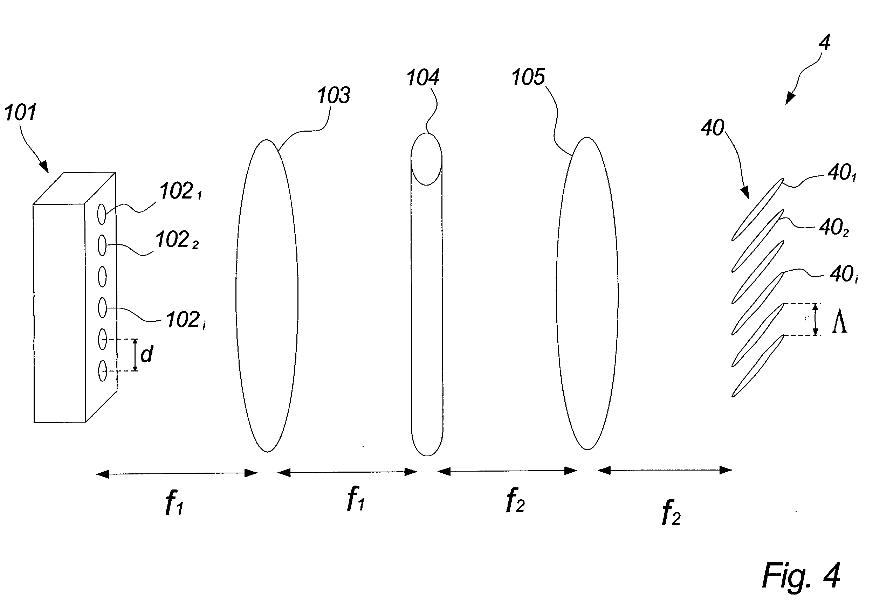

In order to make the fringe spacing independent of the distance from the exit lens, a second imaging lens 105 is arranged in the optical system, such as shown in fig. 4. The fringe spacing is then given by:

$$\Lambda = d \cdot f_2 / f_1,$$

where $f_1$ and $f_2$ are the focal lengths of the first and second lenses 103 and 105.

As shown in fig. 4, the cylinder lens 104 is positioned between the two lenses 103, 105, preferably with a distance to each of the lenses corresponding to the focal length of the respective lens.

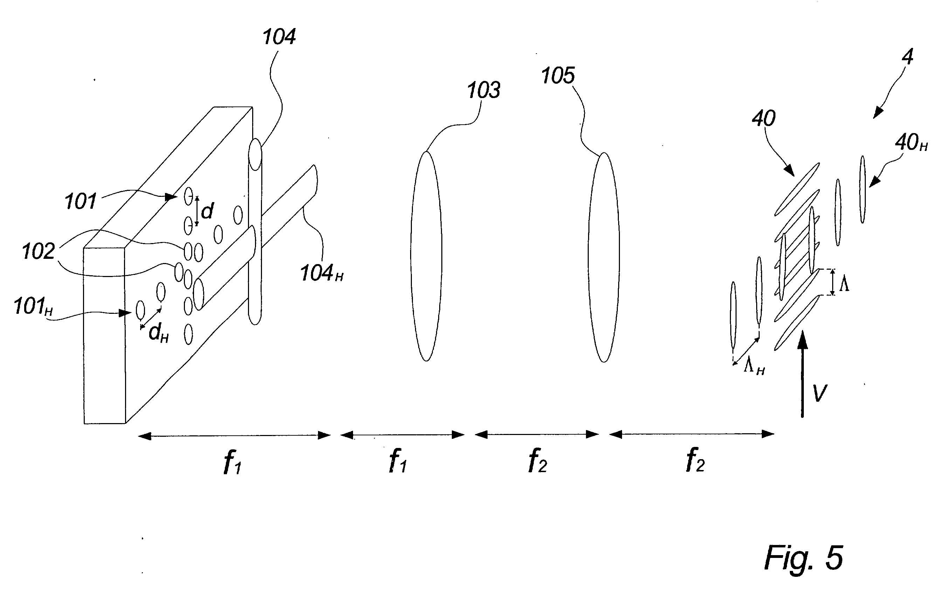

In fig. 5, an embodiment of the invention is shown, where two measurement systems are arranged perpendicular to and overlapping each other. The two arrays of VCSELs 101 and $101_H$ are provided with VCSELs transmitting with different wavelengths. The fringe patterns for each of the arrays are overlapping in the measurement volume 4. Hereby, it is easy to distinguish the measurements in the two directions from each other in the receiver (not shown) by inserting appropriate spectral filters in front of the detectors. Another way of distinguishing the light scattered from the linear VCSEL arrays could be by imposing different modulation frequencies.

The optical system is common to both measurement systems as the imaging lenses 103 and 105 focus the emitted light from both arrays 101, $101_H$. However, two additional cylinder lenses 104, $104_H$ may be provided in order to form linear fringes 40, $40_H$ in both directions. Other fringe-producing light manipulation means may of cause be provided instead - or in addition - to the cylinder lenses 104, $104_H$, e.g. an inclined common cylinder lens having a cylinder axis different from both linear arrays.

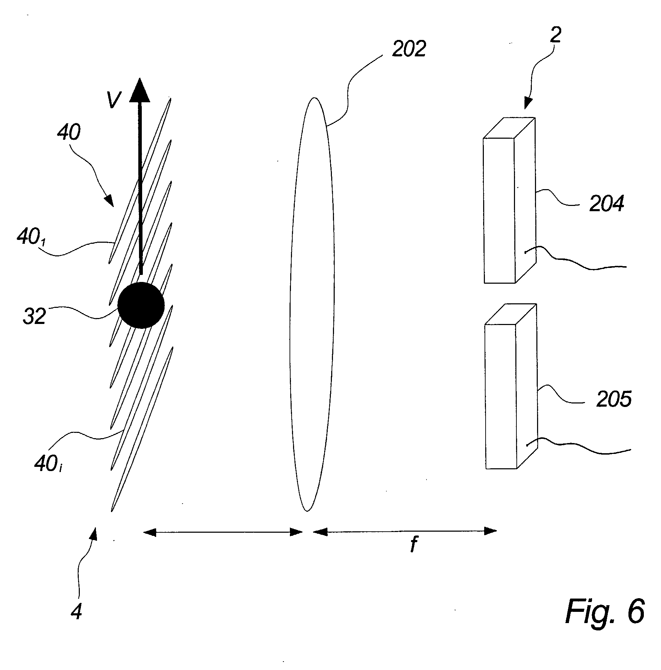

In fig. 6, a special embodiment of a system for velocity measurement according to the invention is shown. According to this embodiment, two detectors 204 and 205 are successively arranged at a distance $f$ from the receiving imaging lens 202 of the receiving means 2. Preferably, this distance is also the focal distance $f$ of the lens 202. The receiving means 2 may advantageously be positioned such that the distance $f$ between the lens 202 to the measurement volume 4 and the array of fringes 40 also equals the focal length of the lens 202. The system in this embodiment can be set up in both back- and forward scatter mode. When a particle 32 with a size larger than or comparable with the fringe thickness passes through the measurement volume 4, the light from a particular fringe $40_i$ is directed toward the first detector 204 as the first part of the particle is scattered with light from this fringe $40_i$. As the particle moves further forward, this fringe $40_i$ is then directed towards the second detector 205. The signal in the two detectors 204, 205 have the same frequency but may have a phase shift that depends on the ratio between the particle size compared with the fringe spacing and the ratio between the detector spacing and the focal length f of the lens 202. Hereby, the direction of the particle movement may be determined by comparing the two signals in the detectors. Besides, information on the particle size will be present in the phase shift between the two signals.

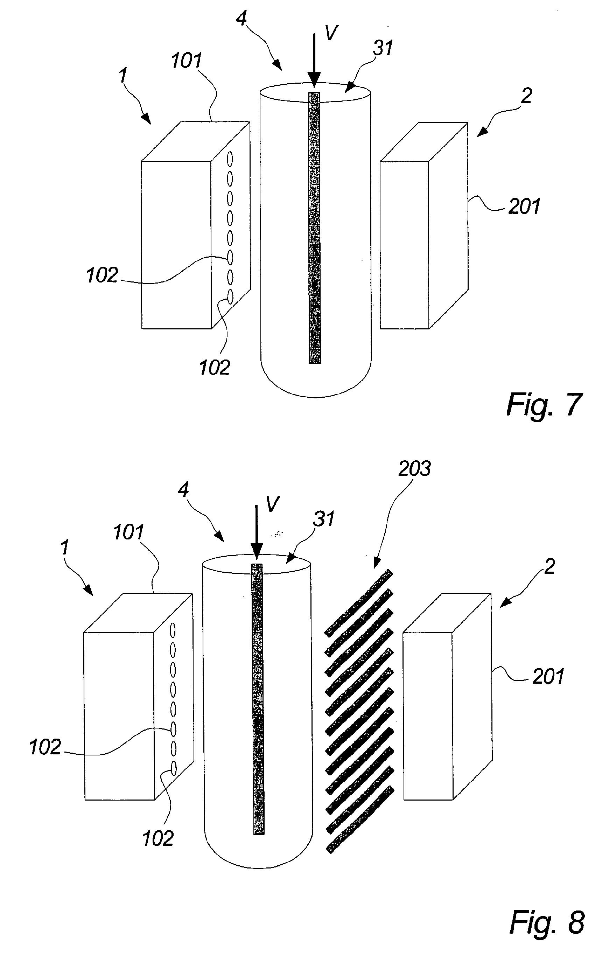

In figs. 7 and 8, a compact and simple configuration of a device for velocity measurement of fluid flow is shown. According to this embodiment, a transmitter 1 and a receiver 2 are arranged closely on each side of a capillary tube 31 in which a fluid with light-scattering particles flows at a certain flow rate $v$, such that the particles will shadow an incident beam from a light source 102 in the VCSEL array 101. The emitted beams from the linear array 101 of light sources 102 are received in one elongated detector 201. By processing the signals received in the detector 201, the velocity of the flow may be determined. In order to enhance the information in the signals received by the detector 201 a grating 203 may be placed in front of the detector 201.

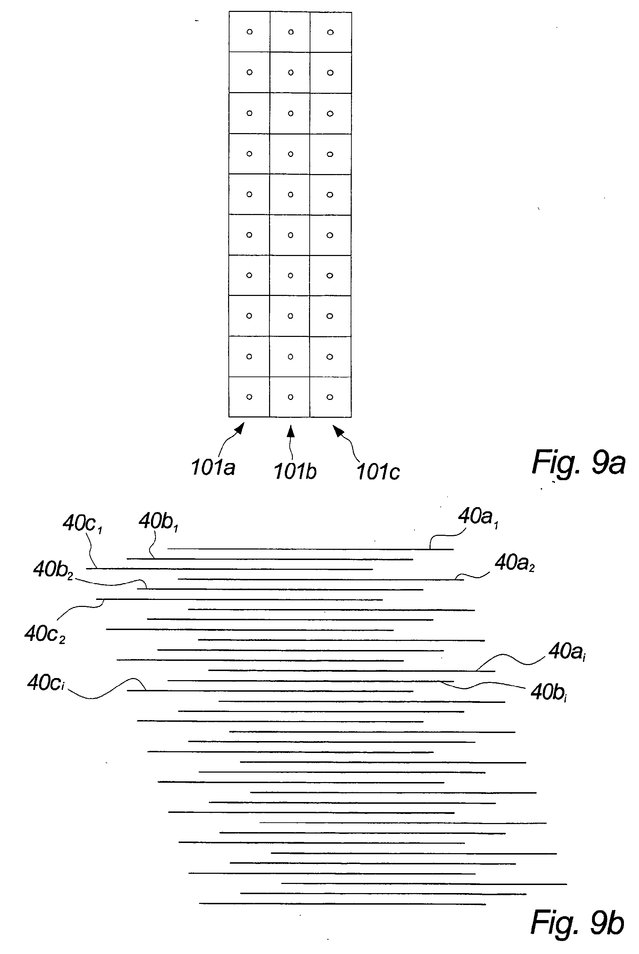

In another preferred embodiment of the invention, it is realised that a higher light source density and a smaller fringe spacing may be obtained by placing a number $p$ of linear arrays $101_a$, $101_b$, $101_c$ beside each other with N VCSELs in each array producing a *p x N* VCSEL array, as shown in fig. 9 a). By rotating the centre line of the cylindrical lens 104 relative to the array (see e.g. figs. 3 or 4), a compact profile of equidistant fringes $40_{a1}, 40_{b1}, 40_{c1}$ ; $40_{a2}, 40_{b2}, 40_{c2}$ ; $40_{ai}, 40_{bi}, 40_{ci}$ in the measurement volume may be obtained, as shown in fig. 9 b). Hereby, the effective fringe spacing may be reduced and the number of fringes increased and thus the accuracy of the measurement will be enhanced.

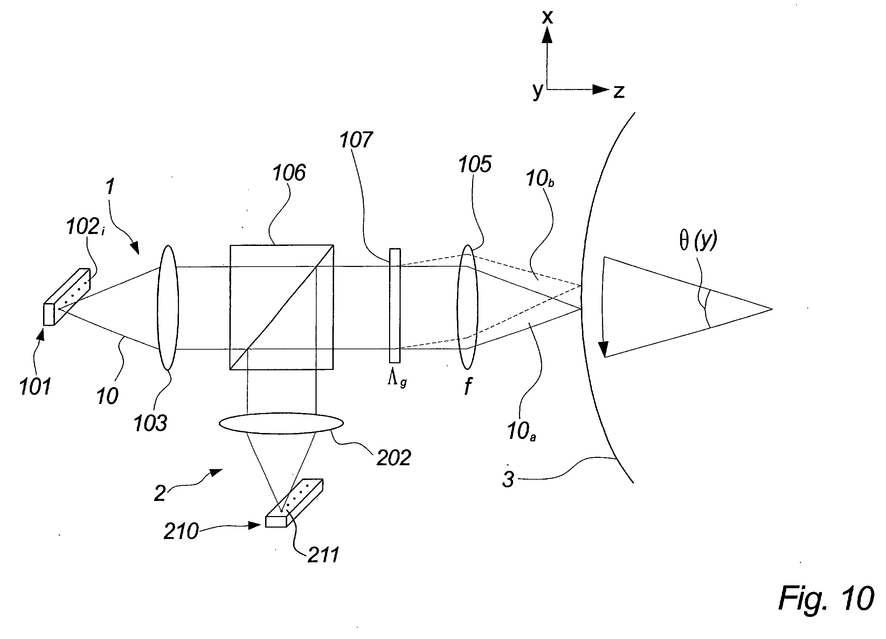

A particular embodiment for measuring torsional twist is shown in figure 10. Lens 103 collimates the laser beams 10 emitted from the VCSEL array 101. The grating 107 and lens 105 provide two sub-beams $10_a$, $10_b$ for each VCSEL. A given pair of sub-beams $10_a$, $10_b$ are being focused onto the target 3 by lens 105, and they intersects the target surface 3 at different angles (approximately of opposite sign).

The backscattered light is collected by lens 105, combined by the grating 107, redirected by beam splitter 106 and imaged by lens 202 onto the detector plane 211. Optical interferometric mixing of a pair of sub-beams $10_a$, $10_b$ at a given detector 210 gives due to Doppler shift the rotational speed of the target 3 in the corresponding point of illumination. An array of detectors 210 corresponding to the VCSEL array 101 is provided in this embodiment, although only one detector 210 is shown in the figure. Each detector 210 (and the corresponding VCSEL) provides one measurement of rotational speed at a different position along the *y*-axis. Hereby, it is possible to measure out of plane relative angular displacement about the *y*-axis as a function of the *y*-position i.e. along the shaft, e.g. the torsional twist of a structure. The relative displacement is given by:

$$\Delta\Phi(y) = 4\pi\, f\, \theta(y)\, /\Lambda_g,$$

where

$\Delta\Phi(y)$    is the phase change of the detected signal at position *y*,

*f*    is the focal length of the exit lens,

$\theta(y)$    is the angular displacement about the *y*-axis as a function of *y*, and

$\Lambda_g$    is the fringe spacing of the grating or diffractive optical element.

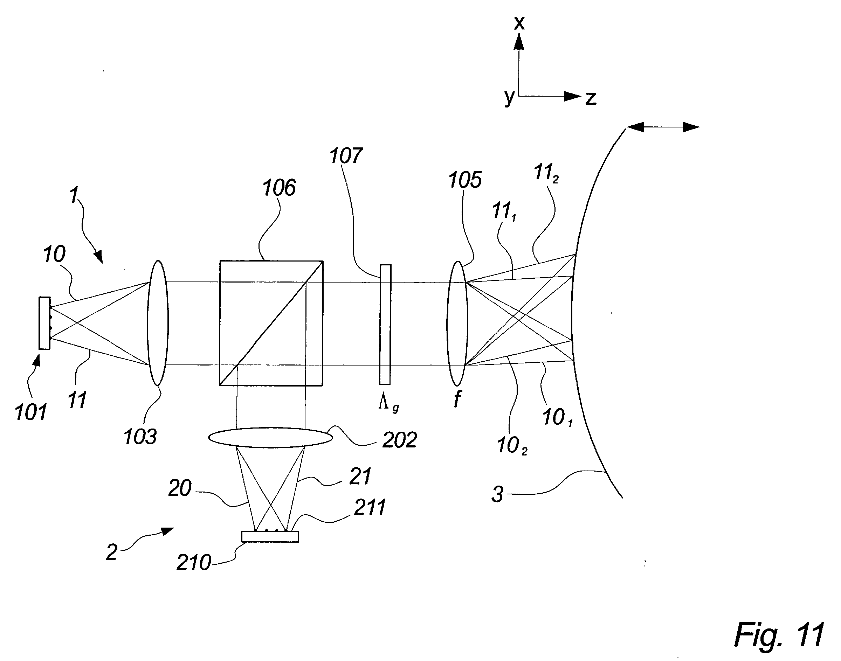

In figure 11, a device for measuring tilt, bending or vibration is shown. The laser beams 10, 11 from the VCSEL array are collimated by lens 103. A grating 107 splits each laser beam 10, 11 in to two other sub-beams $10_1$, $10_2$ ; $11_1$, $11_2$ slightly shifted in angle of propagation. Lens 105 focuses all the laser beams $10_1$, $10_2$ ; $11_1$, $11_2$ onto the target surface in order to form a line of probing points of along the *x*-axis, where each probing point then consists of two slightly shifted illuminating spots (due to one pair of sub-beams) $10_1$, $10_2$, $11_1$, $11_2$ etc. The target is imaged onto the detector array 210 via lens 105, beamsplitter 106 and lens 202. The scattered light from two illuminated spots in a given probing point will be combined to one image point in the detector plane 211 by reversing through the grating, and optical mixing will provide the optical path difference experienced by the corresponding sub-beams. Therefore, the -tilt of the target surface about the *y*-axis as a function of the positions of the probing points along the *x*-axis can be determined-:

$$\Delta\varphi(x) = \frac{4\cdot\pi\cdot f}{\Lambda_g}\cdot\frac{\partial z}{\partial x}(x)$$

where

$\Delta\varphi$    is the optical phase difference experienced by a pair of sub-beams on their way from the grating, to the target and back,

*f*    is the focal length of the exit lens,

$\Lambda_g$    is the fringe spacing of an intermediate grating, and

$\frac{\partial z}{\partial x}(x)$    is the tilt/bending of the surface about the *y*-axis as a function of *x*.

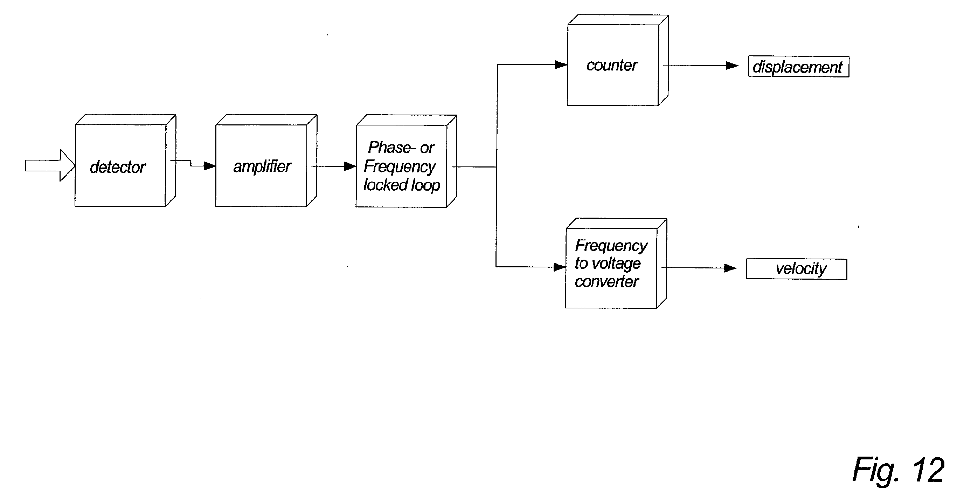

The electronic processing of the detector signals may be adapted to the nature of the signal velocity measurement to be performed. In figures 12 to 14, different ways of carrying out the electronic processing are shown.

In fig. 12, a flow chart for an electronic signal processing for velocity measurements of many particles or a solid surface in a frequency mode is shown. According to this embodiment, the signal from the detector is amplified in an amplifier and then locked in a phase- or frequency locked loop. The phase- or frequency locked loop signal may be processed by a counter for determination of the displacement of the particles or solid surface in the measurement volume. The output from the phase- or frequency locked loop may also be processed in a frequency to voltage converter for giving of the instantaneous velocity.

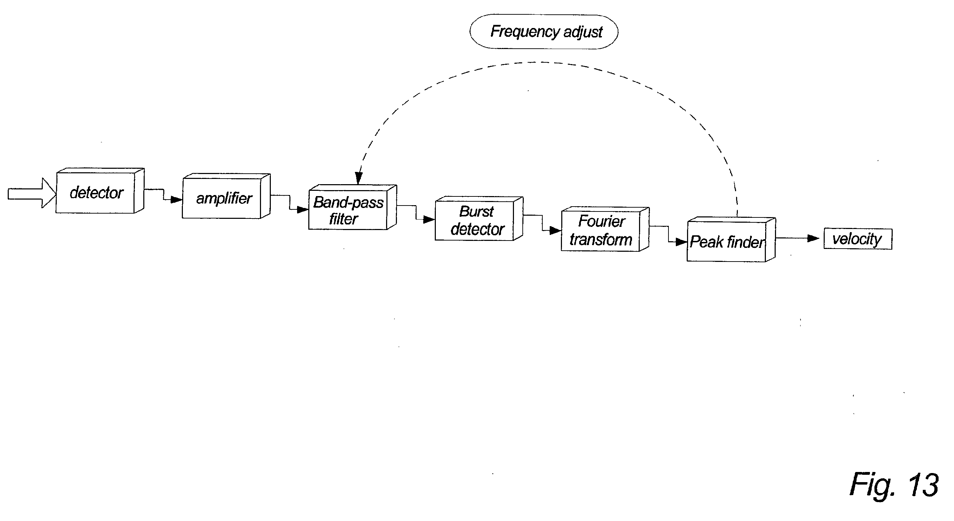

In fig. 13, a flow chart for a frequency mode electronic processing adapted to velocity measurement of single particles, e.g. in relation to flow measurement is shown. In this embodiment, the detector signal is amplified and then processed in a band-pass filter in order to attenuate frequency components of the signal outside a certain frequency range. The filtered signal is processed by a burst detector and then analysed in order to determine the velocity of the measured particles. This involves a Fourier transformation of the burst detected signal and then find the peaks of the signal. The quality of the signal of the peak finder may be improved by a frequency adjustment of the band-pass filter in response to the quality of the peak finder. Besides, wavelet transformation could be advantageous for signal processing.

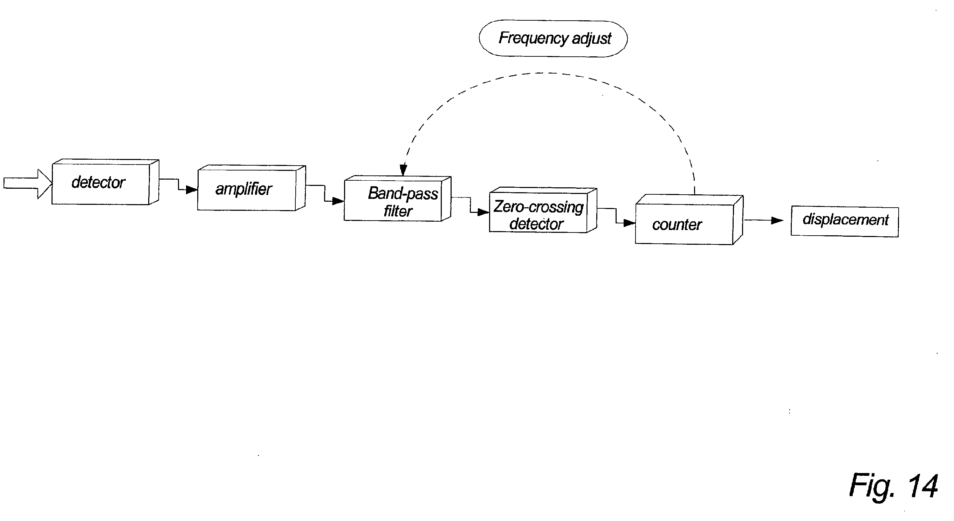

The electronic processing shown in a zero crossing mode is shown in fig. 14. The detector signal is amplified and processed in a band-pass filter. This filtered signal is analysed for zero-crossings so that a counter may determine the displacement. If the quality of the signal in the counter may be assessed and if deemed appropriate, the signal may be improved by a frequency adjustment of the band-pass filter.

By the invention it is realised that variations of the embodiments of the invention and equivalents thereof may be provided without departing from the scope of the invention as set forth in the accompanying claims.

## Claims

1.  A device for measuring the velocity of objects, particles or fluid flow, comprising

    transmitter means (1) comprising

    at least one linear array (101) of surface emitting light sources $(102_x)$, said light sources (102) being arranged in a linear configuration spaced apart by a predetermined separation distance *(d)*,

    an optical system (103-105) including at least one imaging lens directing the electromagnetic radiation (10) emitted from the light sources (102) into a measurement region in a predetermined manner producing an array of spots or fringes (4) spaced apart with a predetermined fringe distance *(Λ)* corresponding to the separation distance *(d)* between the light sources (102),

    receiver means (2) comprising

    light manipulating means (202, 203) directing the electromagnetic radiation (20) scattered from the measurement region to

    detection means including at least one detector (201, 204, 205) detecting the scattered electromagnetic radiation (20) from the measurement region as an object (3) passes through the measurement region,

    detector processing means processing the detected signals from the detector means corresponding to the particle(s) and surface (3) passing the fringes (4) in the measurement region.

2.  A device according to claim 1, wherein the light sources are Vertical Cavity Surface Emitting Laserdiodes (VCSEL) (102).

3.  A device according to claim 1 or 2, wherein the optical transmission system includes a cylinder lens (104).

4.  A device according to any of the claims 1 to 3, wherein the optical system includes two lenses (103, 105) arranged in a telescopic set-up.

5.  A device according to the claim 1 to 4, wherein the cylinder lens (104) is positioned with the lens centre line generally parallel or perpendicular to the linear direction of the laser source array (101).

6.  A device according to the claim 1 to 5, wherein the cylinder lens (104) is positioned with the lens centre line inclined relative to the linear direction of the laser source array or arrays (101).

7.  A device according to the claim 1 to 6, wherein a plurality of linear arrays $(101_{a-c})$ of laser sources (102) is parallelly arranged.

8.  A device according to the claim 1 to 6, wherein two linear laser source arrays $(101, 101_H)$ are arranged in two directions, preferably mutually orthogonal.

9.  A device according to claim 8, wherein the emitted electromagnetic radiation has different wavelengths and/or modulation frequencies of the output intensities in each of the arrays $(101, 101_H; 101_{a-c})$.

10. A device according to the claim 1 to 9, wherein two detectors (204, 205) are successively arranged in the direction of measurement.

11. A device according to any of the claims 1 to 10, wherein the receiving means (2) are located in a position such that the received electromagnetic radiation (20) is back-scattered radiation of the emitted electromagnetic radiation (10) from the object (3) in the measurement region.

12. A device according to claim 11, wherein the optical system includes a beam splitter (106) diverting the electromagnetic radiation (20) scattered back from the object (3) to the receiver means (2).

13. A device according to claim 12, wherein a grating or a diffractive optical element (107) with grating lines perpendicular to the laser array (101) are provided, and where an array of detectors (210) corresponding to the laser array (101) is arranged.

14. A device according to claim 12, wherein a grating or a diffractive optical element (107) with grating lines parallel to the laser array (101) are provided.

15. A device according to any of the claims 1 to 10, wherein the receiving means (2) are located in a position such that the emitted electromagnetic radiation (10) is scattered by an object or a flow of particles (3, 31) passing through the measurement region (4) and being received by the receiving means (2) downstream the transmitter means.

16. A device according to claim 15, where an optical transmission grating (203) is arranged before the detector (201).

17. A device according to any of the preceding claims, wherein the output power of each laser source (102) in the array (101) may be controlled independently.

18. A device according to any of the preceding claims, wherein electromagnetic radiation from the surface emitting laser source array (101) is provided with a coding, such as running light, pulses, phase or frequency shifts of intensity modulation or the like, for distinguishing the individual laser sources (102) and/or each array of laser sources (101, $101_H$; $101_a$, $101_b$, $101_c$) from one another.

19. A device according to any of the preceding claims, wherein the signal processing means involves means for determining displacement, velocity and/or acceleration of a single particle.

20. A device according to any of the claims 1 to 19, wherein the signal processing means involves means for determining the displacement and/or the velocity of a solid surface or a flow of many particles.

21. A device according to any of the claim 1 to 6, wherein the surface emitting light sources are light emitting diodes (LED's), preferably high effect, infra red LED's.

22. A device for measuring the velocity of objects, particles or fluid flow, comprising

transmitter means (1) comprising

at least one linear array (101) of surface emitting laser sources, such as VCSELs ($102_x$), said laser sources (102) being arranged in a linear configuration spaced apart by a predetermined separation distance ($d$) producing an array of fringes in a measurement region,

receiver means (2) comprising

light manipulating means (203) directing the electromagnetic radiation scattered from the measurement region to

detection means including a detector (201) detecting the scattered electromagnetic radiation from the measurement region as an object (3) passes through the measurement region,

detector processing means processing the detected signals from the detector means corresponding to the particle (3) passing the fringes (4) in the measurement region.

23. A method of measuring the velocity of an object, a particle, or a fluid flow, by performing the steps of:

- emitting electromagnetic radiation from a transmitter comprising at least one linear array (101) of surface emitting light sources ($102_x$), said light sources (102) being arranged in a linear configuration spaced apart by a predetermined separation distance ($d$), through

an optical system (103-105) including at least one imaging lens directing the electromagnetic radiation (10) emitted from the light sources (102), into

a measurement region producing an array of spots or fringes (4) spaced apart with a predetermined fringe distance ($\Lambda$) corresponding to the separation distance ($d$) between the light sources (102),

- receiving the electromagnetic radiation (20) scattered from the measurement region in detection means including a detector (201, 204, 205) detecting the scattered electromagnetic radiation (20) from the measurement region as an object (3) passes through the measurement region, and

- processing the detected signals from the detector means corresponding to the object (3) passing the fringes (4) in the measurement region to determine the velocity of the object or particle involved.

24. A method according to claim 23, wherein the light sources are Vertical Cavity Surface Emitting Laserdiodes (VCSEL) (102).

25. A method according to claims 23 or 24, wherein the fringes (40) that are produced by the optical system are widened by a cylinder lens (104).

26. A method according to claims 23 to 25, wherein the optical system of the transmitter (1) includes two lenses (103, 105) arranged in a telescopic set-up.

**27.** A method according to claims 23 to 26, wherein the cylinder lens (104) is positioned with the lens centre line generally parallel to the linear direction of the laser source array (101).

**28.** A method according to claims 23 to 26, wherein the cylinder lens (104) is positioned with the lens centre line inclined relative to the linear direction of the laser source array or arrays (101).

**29.** A method according to claims 23 to 28, wherein a plurality of linear arrays (101$_a$, 101$_b$, 101$_c$) of surface emitting light sources (102) are parallelly arranged.

**30.** A method according to claims 23 to 28, wherein a two linear surface emitting light source arrays (101, 101$_H$) are arranged in two directions, preferably mutually orthogonal.

**31.** A method according to claim 30, wherein the emitted electromagnetic radiation has different wavelengths and/or different modulation frequencies of the output intensities in each of the arrays (101, 101$_H$; 101$_{a-c}$).

**32.** A method according to claims 23 to 31, wherein two detectors (204, 205) are successively arranged in the direction of measurement.

**33.** A method according to claims 23 to 32, wherein the receiving means are located in a position such that the received electromagnetic radiation (20) is backscattered, the emitted electromagnetic radiation (10) from the object (3) in the measurement region.

**34.** A method according to claim 33, wherein the optical system includes a beam splitter diverting the electromagnetic radiation (20) reflected from the object to the receiver means.

**35.** A method according to claim 34, wherein grating or diffractive optical element (107) with grating lines perpendicular to the surface emitting laser array (101) are provided, and where an array of detectors (210) corresponding to the surface emitting laser array (101) is arranged.

**36.** A method according to claim 34, wherein grating or diffractive optical element (107) with grating lines parallel to the surface emitting laser array (101) are provided, and where an array of detectors (210) is arranged.

**37.** A method according to any of the claims 23 to 32, wherein the receiving means (2) are located in a position such that the emitted electromagnetic radiation (10) is scattered by an object (3) passing the measurement region (4) being received by the receiving means (2, 201) downstream the light transmitting means (1).

**38.** A method according to claim 37, where an optical transmission grating (203) is arranged before the detector (201).

**39.** A method according to claims 23 to 38, wherein each surface emitting laser source (102) in the array (101) may be controlled independently.

**40.** A method according to claims 23 to 39, wherein electromagnetic radiation from the surface emitting laser source array (101) is provided with a coding, such as intensity variations, pulses, phase or frequency shifts of intensity modulation or the like, for distinguishing the individual laser sources and/or each array of laser sources from one another.

**41.** A method according to any of the claims 23 to 40, wherein the signal processing involves amplifying the signal from the detector and processing the amplified signal in a phase or frequency locked loop, whereafter the signal is processed in a counter for determining the displacement of the object or particle passing through the measurement region, and/or the signal is processed in a frequency to voltage converter in order to determine the velocity of the object or particle.

EP 1 308 732 A1

*Fig. 1*

EP 1 308 732 A1

*Fig. 2*

*Fig. 3*

EP 1 308 732 A1

101

$102_1$

$102_2$

$102_i$

$d$

103

104

105

4

40

$40_1$

$40_2$

$40_i$

$\Lambda$

$f_1$

$f_1$

$f_2$

$f_2$

*Fig. 4*

EP 1 308 732 A1

*Fig. 5*

Fig. 6

Fig. 7

Fig. 8

101a    101b    101c

*Fig. 9a*

$40c_1$    $40b_1$    $40a_1$

$40b_2$    $40a_2$

$40c_2$

$40a_i$

$40c_i$    $40b_i$

*Fig. 9b*

Fig. 10

EP 1 308 732 A1

EP 1 308 732 A1

x

y ↑ →z

107

106

1

10

105

$11_2$

$11_1$

101

11

103

$\Lambda_g$

202

f

$10_1$

$10_2$

21

20

211

2

210

3

Fig. 11

*Fig. 12*

*Fig. 13*

Fig. 14

**European Patent Office**

# EUROPEAN SEARCH REPORT

Application Number

EP 01 20 4155

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 291 708 A (BUNDESREP DEUTSCHLAND) 23 November 1988 (1988-11-23) * abstract; figure 1 * | 1,22,23 | G01P5/00 H01S5/183 |
| A | AZZAZY M ET AL: "FLOW-VELOCITY MEASUREMENTS WITH A LASER DIODE ARRAY" APPLIED OPTICS, OPTICAL SOCIETY OF AMERICA,WASHINGTON, US, vol. 36, no. 12, 20 April 1997 (1997-04-20), pages 2721-2729, XP000656450 ISSN: 0003-6935 * page 2722, left-hand column, paragraph 3 - page 2722, right-hand column, paragraph 1 * * page 2725, right-hand column * | 1,22,23 | |
| A | US 5 701 172 A (AZZAZY MEDHAT T) 23 December 1997 (1997-12-23) * claims 1-5; figures 1-3 * | 1,22,23 | |
| A | WARREN M E ET AL: "VCSEL APPLICATIONS IN SENSORS AND MICROSYSTEMS" PROCEEDINGS OF THE SPIE, SPIE, BELLINGHAM, VA, US, vol. 3286, 1998, pages 42-51, XP001038629 * page 22, right-hand column, paragraph 2 * | 1,22,23 | TECHNICAL FIELDS SEARCHED (Int.Cl.7) G01P H01S |
| A | EP 0 905 835 A (XEROX CORP) 31 March 1999 (1999-03-31) * page 2, paragraph 2 - page 2, paragraph 3 * * page 11, paragraph 63; claims 1,9 * | 1,22,23 | |

-/--

The present search report has been drawn up for all claims

| Place of search | Date of completion of the search | Examiner |
|---|---|---|
| MUNICH | 23 January 2002 | Felicetti, C |

EPO FORM 1503 03.82 (P04C01)

EP 1 308 732 A1

| European Patent Office | EUROPEAN SEARCH REPORT | Application Number EP 01 20 4155 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | COLDREN L A ET AL: "VCSELS IN '98: WHAT WE HAVE AND WHAT WE CAN EXPECT" PROCEEDINGS OF THE SPIE, SPIE, BELLINGHAM, VA, US, vol. 3286, January 1998 (1998-01), pages 2-16, XP000994616 * abstract * | 1,22,23 | |
| A | HENINI M: "Developments continue for VCSEL research" III VS REVIEW, ELSEVIER SCIENCE PUBLISHERS, OXFORD, GB, vol. 13, no. 1, January 2000 (2000-01), pages 18,20-23, XP004193990 ISSN: 0961-1290 * page 42, paragraph 3 - page 44, paragraph 1 * | 1,22,23 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 23 January 2002 | Felicetti, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

25

EP 1 308 732 A1

## ANNEX TO THE EUROPEAN SEARCH REPORT
## ON EUROPEAN PATENT APPLICATION NO.

EP 01 20 4155

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2002

| Patent document cited in search report | | Publication date | Patent family member(s) | | Publication date |
|---|---|---|---|---|---|
| EP 0291708 | A | 23-11-1988 | DE | 3716249 A1 | 01-12-1988 |
| | | | DE | 3736805 A1 | 11-05-1989 |
| | | | AT | 66074 T | 15-08-1991 |
| | | | CA | 1316705 A1 | 27-04-1993 |
| | | | DE | 3864073 D1 | 12-09-1991 |
| | | | DK | 245988 A | 16-11-1988 |
| | | | EP | 0291708 A2 | 23-11-1988 |
| | | | JP | 1112165 A | 28-04-1989 |
| | | | JP | 7026974 B | 29-03-1995 |
| | | | LV | 5691 A3 | 20-10-1994 |
| | | | SU | 1789050 A3 | 15-01-1993 |
| | | | US | 4923298 A | 08-05-1990 |
| US 5701172 | A | 23-12-1997 | WO | 9924792 A1 | 20-05-1999 |
| | | | AU | 5430598 A | 31-05-1999 |
| EP 0905835 | A | 31-03-1999 | EP | 0905835 A1 | 31-03-1999 |
| | | | JP | 11150340 A | 02-06-1999 |